(19) Europäisches Patentamt
European Patent Office
Office européen des brevets

(11) Veröffentlichungsnummer: **0 214 664 B1**

(12) **EUROPÄISCHE PATENTSCHRIFT**

(45) Veröffentlichungstag der Patentschrift: **12.02.92**

(51) Int. Cl.5: **C08G 77/60**, C07F 7/08, G03F 7/26, C01B 31/36, C04B 35/36

(21) Anmeldenummer: **86112560.7**

(22) Anmeldetag: **10.09.86**

Die Akte enthält technische Angaben, die nach dem Eingang der Anmeldung eingereicht wurden und die nicht in dieser Patentschrift enthalten sind.

(54) **Verfahren zur Herstellung von Organopolysilanen und Verwendung der so hergestellten Organopolysilane.**

(30) Priorität: **10.09.85 DE 3532128**

(43) Veröffentlichungstag der Anmeldung:
**18.03.87 Patentblatt 87/12**

(45) Bekanntmachung des Hinweises auf die Patenterteilung:
**12.02.92 Patentblatt 92/07**

(84) Benannte Vertragsstaaten:
**AT BE CH DE FR GB IT LI NL**

(56) Entgegenhaltungen:
**FR-A- 2 565 234**
**GB-A- 828 843**
**US-E- 31 447**

(73) Patentinhaber: **WACKER-CHEMIE GMBH**
**Hanns-Seidel-Platz 4**
**W-8000 München 83(DE)**

(72) Erfinder: **Frey, Volker, Dr. Dipl.-Chem.**
**Jahnweg 5**
**W-8263 Burghausen(DE)**
Erfinder: **Pachaly, Bernd, Dr. Dipl.-Chem.**
**Bachstrasse 16**
**W-8263 Burghausen(DE)**
Erfinder: **Zeller, Norbert, Dr. Dipl.-Chem.**
**Schweitzer Strasse 5**
**W-8263 Burghausen(DE)**

EP 0 214 664 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Aus US Re. 31 447 (ausgegeben: 22. November 1983, Baney et al., Dow Corning Corporation) ist ein zweistufiges Verfahren zur Herstellung von Organopolysilanen mit SiOC-gebundenen Methoxygruppen bekannt.

Es ist nun Aufgabe der Erfindung, ein einfaches, einstufiges Verfahren zur Herstellung von Organopolysilanen, die schmelzbar und in organischem Lösungsmittel löslich sind, mehr als 7 Siliciumatome je Molekül aufweisen, monomodale und symmetrische Molekulargewichtsverteilung haben, frei von Si-gebundenem Halogen und an der Luft nicht selbstentzündlich sind sowie Ultraviolettlicht mit Wellenlängen unterhalb 360 nanometer absorbieren und durch derartiges Licht vernetzt werden, mit verhältnismäßig guten Ausbeuten bereitzustellen. Diese Aufgabe wird durch die Erfindung gelöst.

Gegenstand der Erfindung ist ein Verfahren zur Herstellung von Organopolysilanen, dadurch gekennzeichnet, daß mindestens ein Disilan der Formel

$R_2R^1Si_2(OCH_3)_3$ ,

worin R gleiche oder verschiedene, einwertige Alkyl-, Alkenyl- oder Arylgruppen und $R^1$ gleiche oder verschiedene, einwertige Alkylgruppen bedeutet, gegebenenfalls im Gemisch mit einer Verbindung der Formel

$R_2Si_2(OCH_3)_4$ ,

worin R die oben dafür angegebene Bedeutung hat, mit mindestens einer Verbindung der Formel

$R_2R^2SiH$ ,

worin R die oben dafür angegebene Bedeutung hat und $R^2$ die Methoxygruppe bedeutet oder die gleiche Bedeutung wie R hat, in Gegenwart von mindestens einer Verbindung der Formel

MOR ,

worin R die oben dafür angegebene Bedeutung hat und M ein Alkalimetall bedeutet, umgesetzt wird.

Vorzugsweise enthalten Alkylgruppen R, $R^1$ und $R^2$ jeweils 1 bis 12 Kohlenstoffatome je Rest, wie der Methyl-, Ethyl-, n-Propyl-, Isopropyl-, n-Butyl-, sec.-Butyl- und 2-Ethylhexylrest, sowie Dodecylreste. Beispiele für Arylreste R und $R^2$ sind der Phenylrest und Xenylreste. Insbesondere wegen der leichteren Zugänglichkeit sind als Alkylgruppen R, $R^1$ und $R^2$ Methylgruppen bevorzugt. Das wichtigste Beispiel für eine Alkenylgruppe R ist die Vinylgruppe.

Als weiteres Beispiel für einen Rest R in der Verbindung der Formel

MOR

sei der tert.-Butylrest genannt.

Das Alkalimetall kann Lithium, Natrium, Kalium, Rubidium oder Cäsium sein. Bevorzugt als Alkalimetall in der Verbindung der Formel

MOR

sind Natrium und Kalium.

Beispiele für Disilane, die bei dem erfindungsgemäßen Verfahren bevorzugt eingesetzt werden, sind 1,1,2-Trimethyl-1,2,2-trimethoxydisilan, 1-Phenyl-1,2-dimethyl-1,2,2-trimethoxydisilan und 1-Vinyl-1,2-dimethyl-1,2,2-trimethoxydisilan. Das wichtigste Beispiel für eine Verbindung der Formel

$R_2Si_2(OCH_3)_4$

ist 1,2-Dimethyl-1,1,2,2-tetramethoxydisilan.

Die Herstellung derartiger Silane ist bekannt, z.B. durch E. Hengge et al. in "Monatshefte für Chemie" Band 105, (1974), Seite 671 bis 683, W.H. Atwell et al. in "Journal of Organometallic Chemistry", Band 7, (1967), Seite 71 bis 78, E. Hengge et al. in "Monatshefte für Chemie", Band 99, (1968), Seite 340 bis 346,

und H. Watanabe et al. in "Journal of Organometallic Chemistry", Band 128 (1977), Seite 173 bis 175.

Werden Disilane der Formel

$R_2Si_2(OCH_3)_4$

mitverwendet, werden sie vorzugsweise in Mengen von 0,5 Mol bis 1,5 Mol je Mol Disilan der Formel

$R_2R^1Si_2(OCH_3)_3$

eingesetzt.

Beispiele für Verbindungen der Formel

$R_2R^2SiH$ ,

die bei dem erfindungsgmeäßen Verfahren bevorzugt eingesetzt werden, sind Dimethylmethoxysilan und Diphenylmethylsilan.

Vorzugsweise wird Verbindung der Formel

$R_2R^2SiH$ ,

in Mengen von 0,5 bis 5 Gewichtsprozent, insbesondere 2 bis 4 Gewichtsprozent, jeweils bezogen auf das Gewicht der jeweils eingesetzten Menge an Disilan, verwendet.

Wichtige Beispiele für Verbindungen der Formel

MOR ,

die bei dem erfindungsgemäßen Verfahren eingesetzt werden können, sind Natriummethylat und Kaliumtert.-butylat.

Verbindung der Formel

MOR

dient als Katalysator bei dem erfindungegemäßen Verfahren. Vorzugsweise wird sie in Mengen von 0,2 bis 0,5 Gewichtsprozent, bezogen auf das Gewicht der jeweils eingesetzten Menge an Disilan, verwendet.

Die Umsetzung erfolgt nach Vermischen der Reaktionsteilnehmer und Katalysator bei Temperaturen von 25 °C bis 220 °C und ist beendet, wenn kein monomeres Organomethoxysilan mehr abdestilliert.

Die Umsetzung wird vorzugsweise beim Druck der umgebenden Atmosphäre, also bei 1020 hPa (abs.) oder etwa 1020 hPa (abs.), durchgeführt. Falls erwünscht, können jedoch auch höhere oder niedrigere Drücke angewendet werden.

Der Si-gebundene Wasserstoff in den erfindungsgemäß hergestellten Verbindungen kann durch Umsetzung dieser Verbindungen, z.B. mit Methanol in Gegenwart eines die Silicium-Silicium-Bindung nicht angreifenden Katalysators, wie $H_2PtCl_6 . 6H_2O$, in Alkoxygruppen umgewandelt werden.

Die erfindungsgemäß hergestellten Organopolysilane können für alle Zwecke eingesetzt werden, für die auch bisher Organopolysilane eingesetzt werden konnten, insbesondere zur Herstellung von Siliciumcarbid durch Erwärmen der Organopolysilane auf Temperaturen über 700 °C in inerter Atmosphäre und zur Herstellung von negativen Photoresistbeschichtungen z.B. bei der Erzeugung von Leiterplatten und Halbleiterbauteilen in für die Herstellung von negativen Photoresistbeschichtungen aus Organopolysilanen an sich bekannter Weise, wobei erfindungsgemäßes oder erfindungsgemäß hergestelltes Organopolysilan auf eine geeignete, glatte oder ebene Unterlage wie ein Halbleiterplättchen aufgebracht, durch eine Maske hindurch belichtet wird, wonach die unbelichteten Teile des Organopolysilanüberzugs mit einem Lösungsmittel, wie Toluol, von den belichteten, vernetzten Stellen des Überzugs getrennt werden.

In den folgenden Beispielen beziehen sich alle Angaben von Prozentsätzen auf das Gewicht.

Beispiel 1

Ein durch Vermischen von 1000 g 1,1,2-Trimethyl-1,2,2-trimethoxydisilan mit 30 g (3 %, bezogen auf das Gewicht von eingesetztem Disilan) Diphenylmethylsilan und 3 g (0,3 %, bezogen auf das Gesamtgewicht von eingesetztem Disilan) Natriummethylat bereitetes Gemisch erwärmt sich nach Erreichen einer

Temperatur von 25 °C ohne äußere Wärmezufuhr rasch auf etwa 90°C. Dann wird das Gemisch auf 200°C erwärmt, wobei 700 g eines Gemisches aus Methyltrimethoxysilan und Dimethyldimethoxysilan abdestillieren. Es werden 330 g Rückstand erhalten, der zur Abtrennung von Natriummethylat und unerwünscht niedrigen Oligomeren in 250 ml Toluol gelöst wird. Die so erhaltene Lösung wird ebenfalls zu dem vorstehend angegebenen Zweck auf 0°C gekühlt und mit 750 ml bei 0°C gehaltenen Acetons vermischt, wobei ein weißer Nieder schlag ausfällt, der abfiltriert und bei 16 hPa (abs.) getrocknet wird. Es werden so 264 g des Organopolysilans der Formel

$(C_6H_5)_2(CH_3)Si[Si(CH_3)_2]_n(SiCH_3)_mH$

wobei die Summe von m + n einen Durchschnittswert von etwa 30 hat, erhalten. Das durchschnittliche Molekulargewicht dieses Organopolysilans beträgt etwa 1940. Es hat eine symmetrische, monomodale Molekulargewichtsverteilung und erweicht bei 100°C bis 150°C zu einer Schmelze. Es absorbiert Ultraviolett-Licht zwischen 200 und 350 nanometer. Im Infrarot-Spektrum hat es eine starke Absorptionsbande bei 2070 $cm^{-1}$.

Das gleiche Ergebnis wird bei Verwendung von Kaliumtert.-butylat anstelle von Natriummethylat erhalten.

Beispiel 2

Ein durch Vermischen von 1000 g 1,1,2-Trimethyl-1,2,2-trimethoxydisilan mit 30 g (3 %, bezogen auf das Gewicht des Disilans) Dimethylmethoxysilan und 4 g (0,4 %, bezogen auf das Gewicht des Disilans) Natriummethylat bereitetes Gemisch erwärmt sich nach Erreichen einer Temperatur von 25°C ohne äußere Wärmezufuhr rasch auf etwa 90°C. Dann wird das Gemisch auf 200°C erwärmt, wobei 700 g eines Gemisches aus Methyltrimethoxysilan und Dimethyldimethoxysilan abdestillieren. Es werden 330 g Rückstand erhalten, der zur Abtrennung von Natriummethylat und unerwünscht niedrigen Oligomeren in 250 ml Tetrahydrofuran gelöst wird. Die so erhaltene Lösung wird ebenfalls zu dem vorstehend angegebenen Zweck auf 0°C gekühlt und mit 750 ml bei 0°C gehaltenen Methanols vermischt, wobei ein weißer Niederschlag ausfällt, der abfiltriert und bei 16 hPa (abs.) getrocknet wird. Es werden so 270 g des Organopolysilans der Formel

$$(CH_3)_2(OCH_3)Si[Si(CH_3)_2]_{n^1}(SiCH_3)_{m^1}H$$

wobei die Summe von $m^1$ + $n^1$ einen Durchschnittswert von etwa 20 hat, erhalten. Das durchschnittliche Molekulargewicht dieses Organopolysilans beträgt etwa 1250. Es hat eine symmetrische, monomodale Molekulargewichtsverteilung und erweicht bei 80°C bis 150°C zu einer Schmelze. Es absorbiert Ultraviolett-Licht zwischen 200 und 350 nanometer. Im Infrarot-Spektrum hat es eine starke Absorptionsbande bei 2070 $cm^{-1}$.

Das gleiche Ergebnis wird bei Verwendung von Kaliumtert.-butylat anstelle von Natriummethylat erhalten.

Beispiel 3

Eine Lösung von 2 g des gemäß Beispiel 1 hergestellten Organopolysilans in 40 ml Toluol wird durch Aufschleudern (spin coating) auf eine runde Siliciumscheibe (wafer) mit einem Durchmesser von 4 Zoll (10 cm) aufgetragen. Nach 15 Minuten Vorbacken bei 100°C wird der so erhaltene auf der Siliciumscheibe befindliche Organopolysilanfilm 2 Sekunden mit einer Quecksilberniederdruck-Ultraviolettlampe mit einer Leistung von 450 Watt und einem Maximum der Leistung bei 253,7 Nanometer durch eine quadratische Chrom-auf-Quarz-Test-Maske mit einer Kantenlänge von 5 Zoll (12,5 cm) belichtet. Dann wird die Scheibe zur Entfernung, weil unbelichtetem, Polysilan in Toluol getaucht. Es wird ein scharf aufgelöstes Muster mit einer minimalen Linienbreite von 0,75 Mikrometer erhalten.

Beispiel 4

Ein durch Vermischen von 213 g (1,09 Mol) 1,1,2-Trimethyl-1,2,2-trimethoxydisilan mit 142 g (0,68 Mol) 1,2-Dimethyl-1,1,2,2-tetramethoxydisilan, 10,7 g (3 %, bezogen auf das Gesamtgewicht von eingesetzten

Disilanen) Diphenylmethylsilan und 1,1 g (0,3 %, bezogen auf das Gesamtgewicht von eingesetzten Disilanen) Natriummethylat bereitetes Gemisch erwärmt sich nach Erreichen einer Temperatur von 25 °C ohne äußere Wärmezufuhr rasch auf etwa 90 °C. Dann wird das Gemisch auf 200 °C erwärmt, wobei 277 g eines Gemisches aus Dimethyldimethoxysilan und Methyltrimethoxysilan abdestillieren. Es werden 90 g Rückstand erhalten, der zur Abtrennung von Natriummethylat und unerwünscht niedrigen Oligomeren in 80 ml Toluol gelöst wird. Die so erhaltene Lösung wird ebenfalls zu dem vorstehend angegebenen Zweck auf 0 °C gekühlt und mit 250 ml bei 0 °C gehaltenen Acetons vermischt, wobei ein weißer Niederschlag ausfällt, der abfiltriert und bei 16 hPa (abs.) getrocknet wird. Es werden so 78 g eines Organopolysilans mit durchschnittlich 39 Si-Atomen je Molekül erhalten. Das durchschnittliche Molekulargewicht dieses Organopolysilans beträgt etwa 2400. Es hat eine symmetrische, monomodale Molekulargewichtsverteilung und erweicht bei 100 °C bis 150 °C zu einer Schmelze. Es absorbiert Ultraviolett-Licht zwischen 200 und 350 nanometer. Im Infrarot-Spektrum hat es eine starke Absorptionsbande bei 2070 $cm^{-1}$.

Das gleiche Ergebnis wird bei Verwendung von Kaliumtert.-butylat anstelle von Natriummethylat erhalten.

## Beispiel 5

Ein durch Vermischen von 120 g (0,57 Mol) 1,2-Dimethyl-1,1,2,2-tetramethoxydisilan mit 180 g (0,98 Mol) 1,1,2-Trimethyl-1,2,2-trimethoxydisilan, 8,1 g (2,7 %, bezogen auf das Gesamtgewicht der Disilane) Dimethylmethoxysilan und 1,2 g (0,4 %, bezogen auf das Gesamtgewicht der Disilane) Natriummethylat bereitetes Gemisch erwärmt sich nach Erreichen einer Temperatur von 25 °C ohne äußere Wärmezufuhr rasch auf etwa 90 °C. Dann wird das Gemisch auf 200 °C erwärmt, wobei 223 g eines Gemisches aus Dimethyldimethoxysilan und Methyltrimethoxysilan abdestillieren. Es werden 86 g Rückstand erhalten, der zur Abtrennung von Natriummethylat und unerwünscht niedrigen Oligomeren in 80 ml Tetrahydrofuran gelöst wird. Die so erhaltene Lösung wird ebenfalls zu dem vorstehend angegebenen Zweck auf 0 °C gekühlt und mit 250 ml bei 0 °C gehaltenen Methanols vermischt, wobei ein weißer Niederschlag ausfällt, der abfiltriert und bei 16 hPa (abs.) getrocknet wird. Es werden so 58 g eines Organopolysilans mit durchschnittlich 31 Siliciumatomen je Molekül erhalten. Das durchschnittliche Molekulargewicht dieses Organopolysilans beträgt etwa 1800. Es hat eine symmetrische, monomodale Molekulargewichtsverteilung und erweicht bei 80 °C bis 150 °C zu einer Schmelze. Es absorbiert Ultraviolett-Licht zwischen 200 und 350 nanometer. Im Infrarot-Spektrum hat es eine starke Absorptionsbande bei 2070 $cm^{-1}$.

Das gleiche Ergebnis wird bei Verwendung von Kaliumtert.-butylat anstelle von Natriummethylat erhalten.

## Beispiel 6

In einem Rohrofen werden 50 g des gemaß Beispiel 2 hergestellten Organopolysilans unter Argon mit einer Aufheizgeschwindigkeit von 200 °C je Stunde auf 1300 °C erhitzt. Nach dem Abkühlen auf Raumtemperatur werden 22,5 g schwarzer Siliciumcarbid-Körner erhalten.

## Patentansprüche

1. Verfahren zur Herstellung von Organopolysilanen,
**dadurch gekennzeichnet**,
daß mindestens ein Disilan der Formel

$R_2R^1Si_2(OCH_3)_3$ ,

worin R gleiche oder verschiedene, einwertige Alkyl-, Alkenyl- oder Arylgruppen und $R^1$ gleiche oder verschiedene, einwertige Alkylgruppen bedeutet, gegebenenfalls im Gemisch mit einer Verbindung der Formel

$R_2Si_2(OCH_3)_4$ ,

worin R die oben dafür angegebene Bedeutung hat, mit mindestens einer Verbindung der Formel

$R_2R^2SiH$ ,

worin R die vorstehend dafür angegebene Bedeutung hat, und $R^2$ die Methoxygruppe bedeutet oder die gleiche Bedeutung wie R hat, in Gegenwart von mindestens einer Verbindung der Formel

MOR ,

worin R die oben dafür angegebene Bedeutung hat und M ein Alkalimetall ist, umgesetzt wird.

**Claims**

1. Process for the preparation of organopolysilanes, characterised in that at least one disilane of the formula

$R_2R^1Si_2(OCH_3)_3$,

in which R denotes identical or different, monovalent alkyl, alkenyl or aryl groups and $R^1$ denotes identical or different, monovalent alkyl groups, is reacted, if appropriate in a mixture with a compound of the formula

$R_2Si_2(OCH_3)_4$,

in which R has the abovementioned meaning, with at least one compound of the formula

$R_2R^2SiH$,

in which R has the abovementioned meaning and $R^2$ is a methoxy group or has the same meaning as R, in the presence of at least one compound of the formula

MOR,

in which R has the abovementioned meaning and M is an alkali metal.

**Revendications**

1. Procédé de fabrication d'organopolysilanes, procédé caractérisé en ce que l'on fait réagir un ou plusieurs disilanes de formule :

$R_2R^1Si_2(OCH_3)_3$

dans laquelle R représente des alkyles, alcényles ou aryles monovalents, identiques ou différents, et $R^1$ des alkyles monovalents identiques ou différents, éventuellement en mélange avec un composé de formule :

$R_2Si_2(OCH_3)_4$

R ayant la signification ci-dessus, avec un ou plusieurs composés de formule :

$R_2R^2SiH$

R ayant la signification ci-dessus et $R^2$ désignant le groupe méthoxy ou ayant la même définition que R, en présence d'un ou de plusieurs composés de formule

MOR

R ayant la signification donnée ci-dessus et M désignant un métal alcalin.